(19)

Europäisches
Patentamt
European
Patent Office
Office européen
des brevets

(11) **EP 2 044 692 B1**

(12) **EUROPEAN PATENT SPECIFICATION**

(45) Date of publication and mention
of the grant of the patent:
**16.12.2009 Bulletin 2009/51**

(21) Application number: **06764253.8**

(22) Date of filing: **21.07.2006**

(51) Int Cl.:
**H03M 1/12** *(2006.01)*

(86) International application number:
**PCT/EP2006/064544**

(87) International publication number:
**WO 2008/009316 (24.01.2008 Gazette 2008/04)**

(54) **UNDERSAMPLING OF A REPETITIVE SIGNAL FOR MEASURING TRANSISTION TIMES TO RECONSTRUCT AN ANALOG WAVEFORM**

UNTERABTASTUNG EINES SICH WIEDERHOLENDEN SIGNALS ZUR MESSUNG VON ÜBERGANGSZEITEN ZUR REKONSTRUKTION EINER ANALOGEN SIGNALFORM

SOUS-ÉCHANTILLONNAGE D'UN SIGNAL RÉPÉTITIF POUR MESURE DES TEMPS DE TRANSITION AFIN DE RECONSTRUIRE UNE FORME D'ONDE ANALOGIQUE

(84) Designated Contracting States:
**DE FR**

(43) Date of publication of application:
**08.04.2009 Bulletin 2009/15**

(73) Proprietor: **Verigy (Singapore) Pte. Ltd.
Singapore 768923 (SG)**

(72) Inventors:
• **RIVOIR, Jochen
71106 Magstadt (DE)**

• **LIU, Jinlei
Hollister, CA 95023 (US)**

(74) Representative: **Zimmermann, Tankred Klaus et al
Schoppe, Zimmermann, Stöckeler & Zinkler
Patentanwälte
Postfach 246
82043 Pullach bei München (DE)**

(56) References cited:
**US-A1- 2005 219 107     US-B1- 6 661 836**

**Description**

BACKGROUND ART

The present invention relates to signal processing.

US 6,462,693 B1 discloses converting an analog signal into a quantity of digital signal representations. The method comprises the step of comparing an amplitude value in the analog signal to a quantity of reference amplitude values to determine whether the analog value is greater than or less than a reference value. The method further comprises the step of producing a logic level in a digital signal corresponding to the determination in the step of comparing. The method essentially converts the analog signal to a time representation and then converts the time representation to a digital representation. The apparatus comprises a quantity of comparators each connected to receive the analog signal, separately to receive a different one of the reference values, and to produce the digital signal. The analog signal is reconstructed from the digital representation.

US 6,429,799 B1 discloses converting an analog signal into a digital representation. The method comprises the steps of generating a quantity of time-varying reference signals, comparing an amplitude of the analog signal to an amplitude of each of the reference signals to determine whether the analog signal amplitude is greater than, less than or equal to reference signal amplitudes, and producing a timestamp each time the analog signal and reference signal amplitudes are equal. The apparatus comprises a reference signal generator and a quantity of comparators, each of the comparators being connected to receive the analog signal, separately to receive a different one of the reference signals, and to produce a digital signal. The analog signal may be reconstructed from the digital representation.

US 2004/0070529 A1 discloses preconditioning an analog signal and converting the preconditioned signal into a digital representation. The method comprises preconditioning the analog signal, generating a quantity of reference signals, comparing an amplitude of the preconditioned signal to an amplitude of the reference signals to determine whether the preconditioned signal amplitude is greater than, less than or equal to reference signal amplitudes, and producing a timestamp at a time that the preconditioned signal and reference signal amplitudes are equal. The apparatus comprises a preconditioner, a reference signal generator and a quantity of comparators. A comparator of the quantity of comparators receives the preconditioned signal from the preconditioner, separately receives a reference signal, and produces a digital signal. The preconditioned signal or the analog signal may be reconstructed from the digital representation.

S. Sunter, "An Automated, Complete, Structural Test Solution for SERDES", IEEE International Test Conference, 2004, pp. 95-104, discloses Gigahertz serialization and deserialization (SERDES) which has become a dominant inter-chip and interboard data transmission technique. Signal integrity is the primary factor determining its bit error rate, typically less than 10-12, so the primary production test challenges are testing picosecond jitter and the signal eye opening. Off-chip jitter and rise/fall time measurements are limited by hardware complexity, access, bandwidth, and noise. Published on-chip measurement techniques are limited by delay line jitter. This paper presents a new jitter test technique that has been demonstrated on an FPGA to achieve less than 1 ps RMS self-jitter, and a new signal eye test that has unlimited bandwidth; neither test uses high speed circuitry. The all-digital technique uses the receiver itself to demodulate the signal jitter to a low-speed bit stream that is analyzed by a single-clock domain, synthesizable circuit. This is combined with logic BIST and 1149.6 boundary scan to completely test an IC.

US 2005/219107 A1 discloses a system and a method for providing a successive approximation of a repetitive output signal of a device under test. The system comprises a clock source driving a strobe generator which generates strobe pulses for sampling the output signal of the device under test at a plurality of sampling points. A successive approximation register produces a digital approximation value which is supplied to an inverting input of a summer. The output signal of the device under test is fed to the non-inverting input of the summer. The difference is amplified and converted to a digital signal which is fed to the input of the successive approximation register:

US 6,661,836 B1 discloses a measuring technique utilizing a high-bandwidth under-sampling voltage measuring instrument. A trigger is derived from a signal having a repetitive signal pattern. The signal is compared with a threshold at a plurality of times relative to the trigger during multiple repetitions of the signal pattern ion order to produce measurement samples indicative of the signal level relative to the threshold.

However, there is still a need for efficient signal processing.

DISCLOSURE

It is an object of the invention to enable efficient signal processing. The object is solved by the independent claims. Further embodiments are shown by the dependent claims.

According to an exemplary embodiment of the present invention, a signal processing device for processing a repetitive signal is provided, the device comprising a determining unit for determining a number of points of time for undersampling the repetitive signal, a comparator unit for comparing, at the number of points of time, the repetitive signal with a reference signal, a generation unit for generating digital result signals indicative of the result of the comparing, and an evaluation unit for determining transition times of the digital result signals.

According to another exemplary embodiment, a measurement apparatus is provided, the measurement apparatus comprising a signal processing device having the above-mentioned features for processing a repetitive signal related to a measurement carried out by the measurement apparatus.

According to still another exemplary embodiment, a signal processing method of processing a repetitive signal is provided, the method comprising determining a number of points of time for undersampling the repetitive signal, comparing, at the number of points of time, the repetitive signal with a reference signal, generating digital result signals indicative of the result of the comparing, and determining transition times of the digital result signals.

According to yet another exemplary embodiment, a computer-readable medium is provided, in which a computer program of processing a repetitive signal is stored, which computer program, when being executed by a processor, is adapted to control or carry out the above-mentioned method.

According to a further exemplary embodiment, a program element of processing a repetitive signal is provided, which program element, when being executed by a processor, is adapted to control or carry out the above-mentioned method.

Embodiments of the invention can be partly or entirely embodied or supported by one or more suitable software programs, which can be stored on or otherwise provided by any kind of data carrier, and which might be executed in or by any suitable data processing unit. Software programs or routines can be preferably applied for processing a repetitive signal. The undersampling according to an embodiment of the invention can be performed by a computer program, i.e. by software, or by using one or more special electronic optimization circuits, i.e. in hardware, or in hybrid form, i.e. using software components and hardware components.

According to an exemplary embodiment, a signal having some kind of periodicity (so as to be repeated several times) is processed by undersampling, particularly using a coherent sampling scheme. In this context, the term "undersampling" may denote a sampling scheme in which a signal is sampled with a bandwidth which is less than a reciprocal of a possible time resolution. After having determined several points in time at which the sampling shall be carried out, for instance essentially equidistant points of time, the repetitive signal is compared with a compare or reference signal at these points in time. The result of this comparison may be that the repetitive signal is larger than the reference signal, is smaller than the reference signal or is equal to the reference signal. Thus, some kind of digital result signal may be generated indicative of a result of this comparison. Information about the repetitive signal may be "encoded" in the points of time at which a transition of this digital result signal form "0" to "1", or vice versa, occurs. In other words, an information about the signal to be processed may be included in points of time at which a transition of the logical value of the result of the comparison occurs. The analog signal may be reconstructed from the digital representation.

It may be advantageous to perform so-called "coherent sampling", that is to say to ensure a defined time correlation between the operation of the individual components of the signal processing device, particularly of the unit generating the reference signal and the determining signal. Such a coherence may be obtained, for instance, by providing a common clock signal for such components, or by strictly linking or coupling the timing of such components, for instance using frequency locking or the like.

More particularly, undersampling of an analog signal using coherent digital automatic test equipment (ATE) channels may be performed.

For testing electronic devices, in particular integrated electronic circuits providing digital electronic output signals, a test or stimulus signal may be fed to an input of the device under test (DUT), and the response signal from the device under test may be evaluated by an automatic test equipment, for instance by comparison with expected data. Such an automatic test equipment may have included a particular test functionality, that is to say test functions or routines which the test equipment may carry out. The test functionality may be incorporated in a test equipment in the form of executable software code. When test signals, which may be repetitive signals, are transmitted within such an electronic test device, it may also happen that signals are converted between analog and digital format. In order to perform such a conversion, the undersampling feature according to an exemplary embodiment may be implemented. Benefit may be taken from the fact that such stimulus signals and/or response signals may have a certain periodicity, that is to say may be repetitive signals.

Exemplary embodiments may transform results of such a data processing into a "standard" ADC (analog-to-digital converter) result format. For instance, after having undersampled the repetitive signal a plurality of times with different points of time within the periodicity of the repetitive signal, it may be advantageous to resort the data points so as to get interpolations between data points with each new iteration of the repetitive signal. However, by performing such a resorting, the equidistant character of the signals may be influenced, so that the output signals may be non-equidistantly. Embodiments of the invention may take such non-equidistant signals and post-process them so as to derive an essentially equidistant sequence of output signals, for instance essentially equidistant in time or in frequency.

Particularly, embodiments of the invention may be implemented within an Analog-to-Digital Converter (ADC) in which an analog signal shall be digitized. In other words, an analog waveform may be converted to a digital signal.

In this context, a repetitive signal may be undersampled. In this context, the term "analog" may denote a signal having a continuous level (for instance a modulated radio frequency signal). The term "digital" may particularly denote a signal having discrete levels (for instance a logical value "1" or "0").

An exemplary field of application of embodiments of the invention is "automatic test equipment", i.e. the digitalization of analog test signals in the context of testing a device under test (DUT). Since such a test may be repeatable, thus the concept of undersampling a repetitive signal may be applied.

The term "coherent sampling" may be particularly understood as to be as sub-form of "undersampling". "Undersampling" may denote that the sampling is performed in a slower manner or with a slower sample rate than necessary to capture all required information without repetition. In the context of "coherent sampling", a defined ratio between the sample period and the repetition time of the signal may be ensured or adjusted. When performing such an undersampling, preferably using coherent sampling, the information to be derived is encoded in the transition times of the digital compare signal. The signal is analyzed a plurality of times, for instance three times. For each iteration, new intermediate measurement points are obtained which successively refine the measurement. "Digital undersampling" may be carried out with the goal to measure the transition times or timestamps with increased accuracy. For such a coherent measurement of transition times, the repetitive signal is sampled a plurality of times, and a fractional frequency ratio between signal frequency and sample rate may be selected. Taking this measure, intermediate sample points may be generated, thereby increasing accuracy of the determined transition times. Accuracy may particularly be increased by repeating the waveform a large number of times, and by selecting a sufficiently high sample rate.

According to an exemplary embodiment, an analog-to-digital converter implementing coherent sampling for measuring transition times for reconstructing an analog waveform may be provided. Particularly, such an ADC may be implemented advantageously within a measurement device, like a test device for testing a device under test (DUT).

A control clock unit may provide a clock signal which can be used globally by the signal processing device, thereby enabling coherent time stamping. Coherent sampling may increase accuracy of the sampling at the determined points of time.

Therefore, according to an exemplary embodiment, undersampling (orsome kind of digitization) of repetitive analog signals, including modulated RF signals, may be performed. Such signals may particularly have a frequency range between 100 MHz and 10 GHz. As a modulation scheme, amplitude modulation, frequency modulation or face modulation may be used, for instance.

Such an undersampling may be embedded in the field of automatic test equipment (ATE), where mixed signal/RF tests are performed and where signals can be made repetitive. Thus, any technical field in which repetitive signals occur may be a potential field of application of exemplary embodiments. In many cases, test criteria assume access uniformly the space samples, like from a conventional ADC, or assume access to the signal spectrum.

The term "digital" may denote two levels, independent of time. The term "analog" may denote that the levels are continuous, independent of time. Analog signals may include modulated RF signals. The term "coherent" may denote an N/M frequency or period ratio, wherein N may be the number of sample points and M may be the number of repetitions of the signal to be sampled, and wherein N and M are coprime.

According to an exemplary embodiment, a signal processing device may be provided in which a repetitive analog signal is evaluated. For such an analog signal, a comparison to a known level or to known levels or to any other waveform may be performed. The result of such a comparison may be a digital signal. The digital compare signal may then be coherently sampled so as to obtain digital samples. Next, precise transition times may be determined of compare signals from digital samples. Samples may be constructed using the transition times plus the levels of the known waveform at the transition times.

Optionally, it is possible to compare the repetitive signal to one static level, multiple static levels, sine waves, other dynamic waveforms, or preconditioned signals. It is possible to use a digital ATE channel as coherent sampler. Furthermore, jitter may be selectively added to the signal to improve resolution/accuracy. When detecting transitions, the "first" signal after the transition may be determined, the "last" signal before the transition may be determined, a "mid" time between the last and the first point may be determined, or a "count" may be performed in an interval between measurement points before and after a transition.

According to another exemplary embodiment, an analog signal may be processed by the signal processing device. The analog signal may be compared to known levels. Afterwards, transition times of the compare signal may be determined. Samples may be constructed. These samples may be transformed into a usual "ADC" format. In this context, an interpolation may be performed, NUFFT (Non-Uniform Fast Fourier Transformation) may be performed, and/or a Non-Uniform Discrete Fourier Transformation (NUDFT) may be performed. In the context of the NUDFT, it is possible to perform a direct down conversion of (modulated) RF signals. It is also possible to perform an offset correction by including DC term in NUDFT. Spur suppression may be enabled by including known spur frequencies in NUDFT. Furthermore, noise suppression may be carried out. It is possible to use equally spaced frequencies in a single contiguous frequency range, like in a conventional FFT.

According to an exemplary embodiment, an RF receiver using digital ATE channel may be provided. In this context, a (modulated) narrowband (RF) signal may be used. It may be compared to one (or more) static level(s). A digital ATE channel may be used for coherent sampling. Accurate crossing times may be determined. A narrowband spectrum may be reconstructed (NUDFT). The result may be downconverted by simple frequency shifting.

Next, further exemplary embodiments of the invention will be explained.

In the following, further exemplary embodiments of the signal processing device will be explained. However, these embodiments also apply for the measurement apparatus, for the method, for the program element and for the computer-readable medium.

The signal processing device may be adapted for processing a repetitive analog signal. Such an analog signal may represent any continuous value. The term repetitive may have the meaning that the signal has some kind of periodicity and is repeated a plurality of times.

Furthermore, the signal processing device may be adapted for processing a repetitive modulated radio frequency (RF) signal. Particularly, such a signal processing may be performed in the context of an RF receiver.

The signal processing device may be adapted as an Analog-to-Digital Converter (ADC) for converting a repetitive analog signal into a digital signal. Implementing the coherent sampling in such a conversion may allow to perform the conversion with high precision. Recalculating the result signal so as to obtain equidistantly spaced result signals may simplify the post-processing of such a converted signal.

The determining unit may be adapted for determining different points of time for each of a plurality of repetitions. When different periods of such a repeated signal are compared based on different repetitions, the sampled points of subsequent periods may be shifted with respect to one another. By taking this measure, intermediate points of the sampling may be obtained so as to refine the analysis.

The determining unit may be adapted for determining different points of time for each of a plurality of repetitions so as to obtain essentially uniformly spaced time data. By selecting the ratio between sampled points and number of transitions to be a non-integer value, this uniform spaced time feature may be combined with an efficient way of obtaining intermediate points for each repetition of the signal.

The reference signal may be one of the group consisting of a single signal being constant in time, a plurality of signals each being constant in time, a signal varying in time in accordance with a predefined waveform, and a sine signal. However, any other waveforms are possible, for instance any trigonometric function, a saw tooth function, a step function, etc.

The evaluation unit may be adapted for determining the transition times taking into account the signal at points of time related to different ones of a plurality of repetitions. Thus, different repetition sample signals may be combined to increase accuracy, particularly to obtain intermediate signals between two data points. This may refine the data format conversion.

The number of points of times may be larger than the number of repetitions. The ratio between the number of points of time and the number of repetitions may be a non-integer value. The latter measure may ensure that additional repetitions provide additional information about the signal.

Advantageously, the signal processing device may comprise a sorting unit adapted for sorting the digital result signals related to different repetitions in accordance with a chronology of the corresponding points of time within the periodicity of the repetitive signal. By resorting or reordering the signals after undersampling, the number of points in the environment of a transition of the digital result signal may be refined.

The generation unit may be adapted for generating a digital result signal having a first logical value (for instance "1") in case that the respective repetitive signal is larger than the reference signal, and may be adapted for generating a digital result signal having a second logical value (for instance "0") in case that the respective repetitive signal is smaller than the reference signal. Therefore, the transition time may be calculated as a point of time at which a transition from the first logical value to the second logical value occurs. For this purpose, the evaluation unit may determine the transition times based on an analysis of the last point of time in a sequence in which the digital result signal has the first logical value. Alternatively, a first point of time may be determined as the time of transition in a sequence in which the digital result signal has the second logical value. It is also possible to calculate an average time between this last point of time of the first logical value and the first point of time of the second logical value.

Alternatively, it is possible to further refine the accuracy of estimating the transition time by performing a statistical analysis of a transition interval. For instance, due to effects like jitter, noise or other signal distortions, it may happen that around a transition time, a sequence of alternating values of the first logical value and the second logical value may occur. In such a scenario, it may be more reasonable to statistically analyze the data points in this region and calculate a (most) probable transition time. This may include interpolation, statistically averaging, fitting a mathematical probability function to the determined digital values (some kind of thermometer code), for instance a cumulative probability density function, etc.

The evaluation unit may be adapted to determine the transition times according to an operation mode which is selected in accordance with a degree of presence of signal jitter or signal noise. When signal jitter/noise is large, it is relatively likely that signal distortions occur and that the transition interval comprises some distorted measurement points.

When signal jitter is small, the numerically more easy solution may be preferred, namely to use the last time of the first logical value or the first point of time of the second logical value, or an average thereof, as an actual transition time.

The signal processing device may comprise an output signal calculation unit adapted for calculating essentially uniformly spaced output signals. By the reordering, the equidistance may be achieved. However, it may be desirable for post-processing of the signals, that the signals are essentially uniformly spaced, particularly uniformly spaced in time or uniformly spaced in frequency.

In order to obtain such a uniformly spaced signal, the output signal calculation unit may be adapted for determining the essentially uniformly spaced output signals by using a Sinc interpolation (that is to say a mathematical function being formed by the ratio of the sine of the argument and the argument, wherein the argument may be the time), a polynomial interpolation (for example a Lagrange interpolation, a spline interpolation, or a linear interpolation). It is also possible to implement a fractional delay filter.

The output signal calculation unit may be adapted for calculating the output signal by performing at least one of the group consisting of a Fast Fourier Transformation (FFT), a Non-Uniform Fast Fourier Transformation (NUFFT), a Non-Uniform Fast Fourier Transformation (NUFFT) with Fast Multipole Method (FMM), and a Non-Uniform Discrete Fourier Transformation (NUDFT). Particularly, the signal processing device may be adapted for processing the repetitive signal using coherent sampling. Coherent sampling may denote that the time properties of the sampling are well-established.

Coherent sampling may be enabled by implementing a clock generating unit adapted for generating a common clock signal for a plurality of components of the signal processing device. For instance, such a clock generating unit may supply a common clock signal to a device under test, to a reference signal generator for generating the reference signal and to a unit for evaluating or processing the compare signal. Thus, the clock generating unit may generate a common clock signal for a part of or for all components of the signal processing device.

Alternatively, a plurality of clock generating units may be provided, each adapted for generating an individual clock signal for an assigned component of the signal processing device, wherein the plurality of clock generating units may be frequency-locked. For instance, three frequency-locked generators with the same output frequencies may be provided to generate individual clock signals for the device under test, a reference signal generator and a unit for evaluating the compare signal.

Further alternatively, three independent clock generators with sufficient precision to ensure the desired output frequencies may be implemented.

The signal processing device may further comprise a jitter adding unit adapted to selectively add jitter to the repetitive signal and/or to the compare signal and/or to the coherent sample clock. By taking this measure, the signal may be smeared out in a defined manner which may increase accuracy of the signal conversion.

The signal processing device may comprise an automatic test equipment unit (ATE) providing an environment for the DUT so that the DUT is a source for providing the repetitive signal, like an Agilent 93000 test apparatus. Thus, the signal processing device may particularly be implemented as an ADC of an such an ATE for testing a device under test, for instance a chip for a mobile phone. Such an automatic test equipment may provide an environment for the DUT so that the DUT is the source for providing the repetitive signal, and may be implemented for testing a device under test.

In the following, further exemplary embodiments of the measurement apparatus will be explained. However, these embodiments also apply to the signal processing device, to the method, to the program element and to the computer-readable medium.

A signal generation unit of the measurement apparatus may be adapted to generate, as the repetitive signal or as a basis for a repetitive signal, a stimulus signal to be applied to a device under test for testing the device under test. It is also possible that the DUT generates a repetitive signal based on a (repetitive or non-repetitive) stimulus signal of the measurement apparatus. Such a stimulus signal may be any signal pattern which is applied to pins of a DUT, for instance a chip to be tested, and a response signal can be detected at other pins of the DUT. By comparing such response signals with expected signals, it may be determined whether the device under test is acceptable or has to be rejected. When applying test sequences to such a device under test, the signals are usually repeated a plurality of times. Thus, a signal processing device according to an exemplary embodiment may be advantageously implemented in such a measurement apparatus, particularly in the context of an ADC used for such a measurement apparatus.

The measurement apparatus may further be adapted to receive, as the repetitive signal, a response signal from a device under test in response to applying a stimulus signal to the device under test for testing the device under test. In such a scenario, the device under test may generate the repetitive signal which may then be evaluated by a signal processor of the measurement apparatus.

More particularly, the measurement apparatus may comprise at least one of the group consisting of an Analog-to-Digital Converter (ADC), a sensor device (for instance for sensing a parameter of a DUT), a test device for testing a device under test or a substance (for instance an apparatus of the Agilent 93000 series), a device for chemical, biological and/or pharmaceutical analysis, a fluid separation system adapted for separating compounds of a fluid, a capillary electrophoresis device, a liquid chromatography device, a gas chromatography device, an electronic measurement device, and a mass spectroscopy device. More generally, embodiments may be employed in many fields of electronics and measurement applications, for instance in life science regime, or in any field of analog or digital electronics in which accurate signal conversion or signal processing may be an issue, particularly when a repetitive signal is used.

BRIEF DESCRIPTION OF DRAWINGS

Other objects and many of the attendant advantages of embodiments of the present invention will be readily appreciated and become better understood by reference to the following more detailed description of embodiments in connection with the accompanied drawings. Features that are substantially or functionally equal or similar will be referred to by the same reference signs.

Fig. 1 shows a signal processing device according to an exemplary embodiment of the invention.

Fig. 2 shows diagrams in the context of coherent time stamping.

Fig. 3 illustrates a signal processing device according to an exemplary embodiment.

Fig. 4 shows diagrams illustrating the function of a signal processing device in the presence of jitter.

Fig. 5 shows diagrams illustrating an operation mode of a data processing device in the presence of jitter.

Fig. 6 shows diagrams during an operation of a signal processing device for analog waveform reconstruction according to an exemplary embodiment.

Fig. 7 illustrates a data processing device according to an exemplary embodiment of the invention.

Fig. 8 illustrates uniform interpolation in the context of a signal processing device according to an exemplary embodiment.

Fig. 9 shows a measurement apparatus according to an exemplary embodiment.

The illustration in the drawing is schematically.

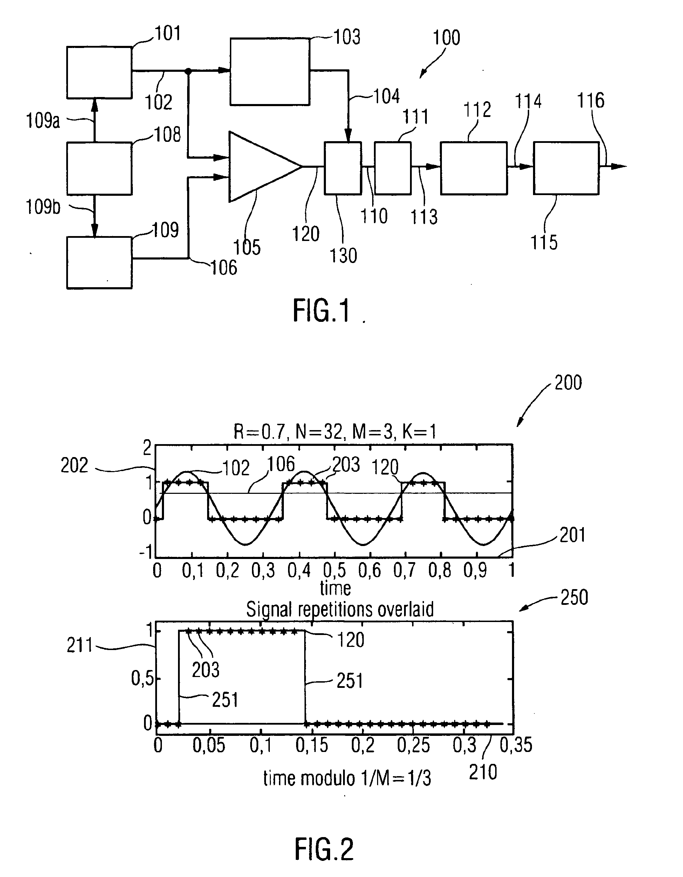

In the following, referring to Fig.1, a signal processing device 100 according to an exemplary embodiment of the invention will be explained.

A repetitive signal source 101 is adapted to generate a periodic repetitive signal 102. The repetitive signal 102 is a periodic signal which is repeated several times. This repetitive signal 102 is used in the context of investigating a device under test. The repetitive signal 102 is supplied to an input of a determining unit 103. The determining unit 103 is adapted for determining a number of points of times for undersampling the repetitive signal 102. These points of times at which the repetitive signal 102 is sampled may be supplied in the form of a control signal 104 to a flip flop 130 located at an output of a comparator unit 105 at which output a comparator signal 120 may be provided indicative of a result of the comparison. A first signal input of the comparator unit 105 is supplied with the repetitive signal 102. A second signal input of the comparator unit 105 is supplied with a reference signal 106 which is generated by a reference signal generator unit 107. As can be taken from Fig. 1, a clock generating unit 108 generates clock signals 109a, 109b which are supplied to the repetitive signal source 101 and the reference signal generator 107, respectively. In this context, it may be ensured that the reference signal source 101 and the reference signal generator 107 are synchronized so as to enable coherent sampling.

The comparator unit 105 is adapted for comparing the repetitive signal 102 with the reference signal 106. A result of this comparison is provided at an output of the comparator unit 105 coupled to an input of the flip flop 130. The flip flop 130 is supplied with the compare signal 120 provided at the output of the comparator unit 105 and generates, taking into account the control signal 104 indicative of a number of specific compare times, a digital result signal 110. The digital result signal 110 is supplied to a re-sorting unit 111 which is adapted for re-sorting the digital result signals 110 related to different repetitions of the repetitive signal 102 in accordance with a chronology of the corresponding points of time defined by the time control signal 104 within the periodicity of the repetitive signal 102 (see Fig. 2). After having reordered the components of the signal 110, it is supplied to an evaluation unit 112 for determining transition times of the digital result signal 110. The transition times are assumed to include the information to be derived by the signal processing of the system 100.

The evaluation unit 112 evaluates, based on the sorted signals 113, transition time signals 114 which are supplied to an output signal generation unit 115. The output signal calculation unit 115 calculates output signals 116 which are essentially uniformly spaced in time and which are supplied at an output of the signal processing device 100.

The repetitive signal 102 is a repetitive analog signal, more particularly a repetitive modulated radio frequency signal. The signal processing device 100 is adapted for analog-to-digital-signal-conversion, so as to provide a digital signal 116 indicative of the analog waveform of the signal 102.

As will be explained below in more detail referring to Fig. 2, the determining unit 103 determines different points of time for each of the plurality of repetitions of the signal 102 at which the comparison is performed by the comparator unit 105. Therefore, the signals generated by the determining unit 103 are essentially uniformly spaced in time. The reference signal 106 is a constant signal in the embodiment of Fig. 1. The digital result signal 110 may have a logical value of "1" in case that, at a particular point of time, the repetitive signal is larger or equal than the reference signal 106. In the alternative case that the repetitive signal is smaller than the reference signal 106, the logical value of the digital result signal 110 is "0".

The output signal calculation unit 115 may perform an interpolation so as to derive the output signal 116 to be essentially uniformly spaced in time. For this purpose, a plurality of signal transformation algorithms may be applied by the output signal generation unit 115.

The clock generation unit 108 generates a first clock signal 109a for the repetitive signal source 101 and a second clock signal 109b for the reference signal generator 107. As an alternative to the provision of two separate clock signals 109a, 109b, it is also possible that the clock generation unit 108 generates a common clock signal for the repetitive signal source 101 and for the reference signal generator 107.

Therefore, the embodiment of Fig. 1 enables a measurement of transition times for analog waveform reconstruction. This will be further clarified on the basis of the diagrams 200 and diagram 250 shown in Fig. 2.

Along an abscissa 201 of the diagram 200, the time is plotted. Along an ordinate 202 of the diagram 200, a signal value is plotted. A first graph shows the repetitive analog signal 102. A second graph shows the constant reference signal 106. Points of time 203 of the step function-like compare signal 120 is further shown in Fig. 2.

A modified time axis 210 (time modulo 1/M=1/3) is shown along an abscissa 210 of the diagram 250. Along an ordinate 211 of the diagram 250, a signal value is plotted. The resorted data points 203 are shown in diagram 250 as well. Furthermore, the compare signal 120 is shown. Beyond this, transition times 251 can be derived from in the diagram 250 of Fig. 2.

According to the nomenclature of Fig. 2, R=0.7 is the value of the reference signal 106, N=32 is the number of data points 203. M=3 is the number of repetitions of the repetitive signal 102. Thus, according to Fig. 2, the signal 102 to be sampled has a sine-like shape, but can have any alternative shape, particularly periodic shape. Advantageously, N and M may be coprime or relatively prime.

According to the described embodiment, the transition times 251 of the repetitive digital compare signal 120 may be evaluated or estimated accurately through coherent digital sampling using a digital ATE channel.

The time interval between two measurement moments 203 may be denoted as $T_S$, and the time duration of a period of the repetitive signal 102 may be denoted as $T_R$. Preferably, the equation $N \times T_S = M \times T_R$ holds, wherein N is coprime M, and $K \times N$ samples are taken. Samples may then be re-ordered according to the sorting scheme $i_{sort}$= mod (i x M, N). The transition time 251 is between the time of the last sample before the transition and the time of the first sample after transition.

With the coherent sampling scheme of the embodiments of Fig. 1 and Fig. 2, arbitrary fine time resolution ($T_s$/ N) may be obtained particularly when N is sufficiently large. An essentially linear time measurement may be made possible (assuming a constant frequency sample clock for $T_s$).

Level accuracy of samples may only be determined by the accuracy of transition time measurements, not for instance by the number of static compare levels.

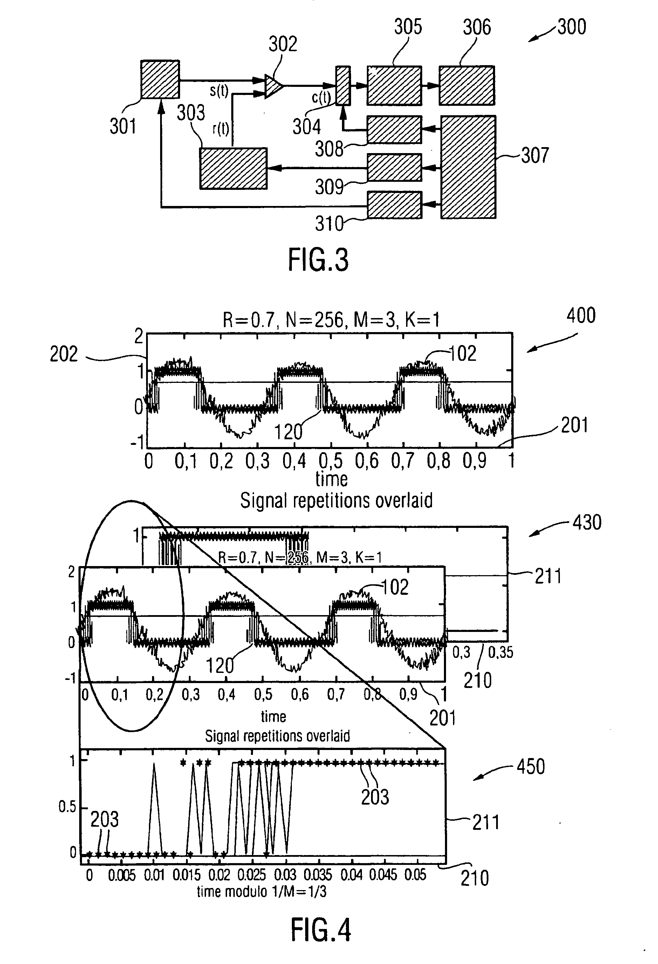

In the following, a coherency feature according to an exemplary embodiment of the invention will be explained based on the signal processing device 300 shown in Fig. 3.

Fig. 3 shows a device under test 301. The device under test 301 generates a signal under test s(t) (wherein t is the time) which is supplied to a first signal input of a comparator 302. A reference signal r(t) is supplied to a second signal input of the comparator 302 and is been generated by a reference signal generator 303. At an output of the comparator 302, a compare signal c(t) is provided which is supplied to a flip-flop 304. The output of the flip-flop 304 is coupled to an input of a memory 305. An output of the memory 305 is coupled to an input of a transition time algorithm unit 306 for determining the desired transition time(s).

Furthermore, the data processing device 300 comprises a common clock generator unit 307 which generates a common clock for different components of the system 300. The clock generator unit 307 is coupled to a divider DN unit 308 for supplying a clock signal to the flip-flop 304. Further, the clock generator unit 307 is coupled to a divider Dref 309 generating a clock signal to be supplied to the reference signal generator 303. Moreover, the clock generator 307 is coupled to a divider DM 310 which is, in turn, coupled to the device under test 301 so as to generate a clock signal for the device under test 301.

According to the embodiment of Fig. 3, coherency may be ensured for instance through the common clock reference. The signal under test repeats after the time $T_R$ (controlled by the divider DN 310). The dynamic reference signal has a period $T_{Ref}$ and is controlled by the divider Dref unit 309. A static compare level requires no clock. Furthermore, a digital sample period $T_s$ may be implemented controlled by the divider unit DM 308.

Alternatively to the embodiment of Fig. 3, there can be three individual frequency-locked clock generators with the same output frequencies. Or, three independent clock generators may be provided with enough precision to ensure the desired output frequencies.

It should be noted that blocks 304 to 306 of the system 300 may be substituted by any desired time to digital converter unit. The conversion from non-equidistant samples into equidistant samples may be performed with any signal processing scheme, more particularly may be applied to any digitalization of a signal with time stamps. In order words, the generation of equidistant samples from non-equidistant samples is not restricted to repetitive signals.

Fig. 4 shows diagrams 400,430,450 illustrating the situation of Fig. 2 in the context of the measurement of transition times of imperfect signals, that is to say of signals which are disturbed by noise and/or jitter.

In the presence of noise or jitter, a better estimate of the time stamp can be obtained by looking at all samples in the vicinity of the transition and choosing an appropriate "average" transition point. That is to say, jitter may allow interpolation between samples. It is also possible to add jitter artificially if not noisy enough (for instance some small PRBS signal to sample clock, or connect a noisy diode to comparator input). The plot in Fig. 4 includes a level of noise of 0.02 rms.

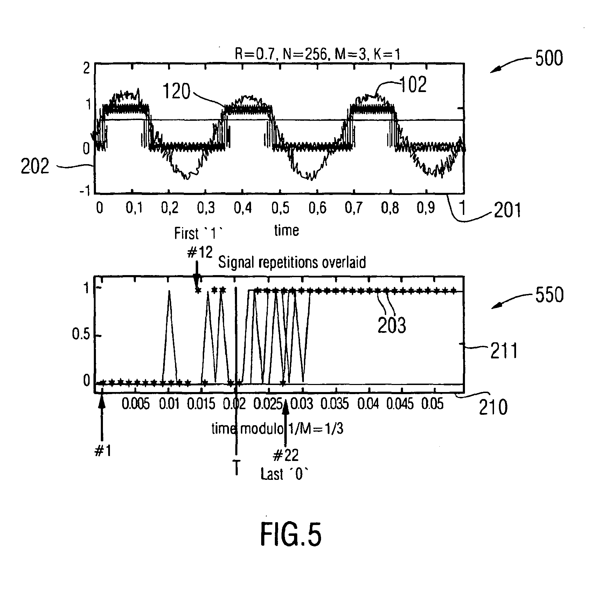

In the following, referring to Fig. 5, measuring transition times of imperfect signals, that is to say signals in the presence of noise or jitter, will be explained in more detail.

Fig. 5 again shows a diagram 500 which is similar to the diagram 400 of Fig. 4 and shows a diagram 550 which is similar to the diagram 450 of Fig. 4.

One easy way of determining a transition time without averaging is to take the first "1". In the scenario of Fig. 5, the measurement point 203 #12 is then selected to be the transition time, so that t=12/256. The total number of samples is 256. Alternatively, the last "0" can be selected, which would result in the estimation of the transition time at measurement point 203 #22.

Alternatively, it is possible to implement some averaging: For example, the middle between the first "1" and the last "0" can be taken. This would result in a transition time t=(22+12)/2/256=17/256.

Alternatively, even more averaging can be involved, which results in a still quite easy calculation scheme and proper results. According to such an embodiment, the values "0" may be counted. This may result in a transition time t=16/256.

An even better estimate of the transition time, but involving more computation, involves searching the time "T" that minimizes the sum of deviations ($E_1$ or $E_2$). S samples around the transitions, i=1,...,S, each with sample time $t_i$, data value $d_i$ ("0" or "1").

The following equation describes the situation for rising transition:

$$E_1 = \sum_{i=1,d_i=1,t_i<T}^{S}(T-t_i) + \sum_{i=1,d_i=0,T\geq t_i}^{S}(t_i-T)$$

$$E_2 = \sum_{i=1,d_i=1,t_i<T}^{S}(T-t_i)^2 + \sum_{i=1,d_i=0,T\geq t_i}^{S}(t_i-T)^2$$

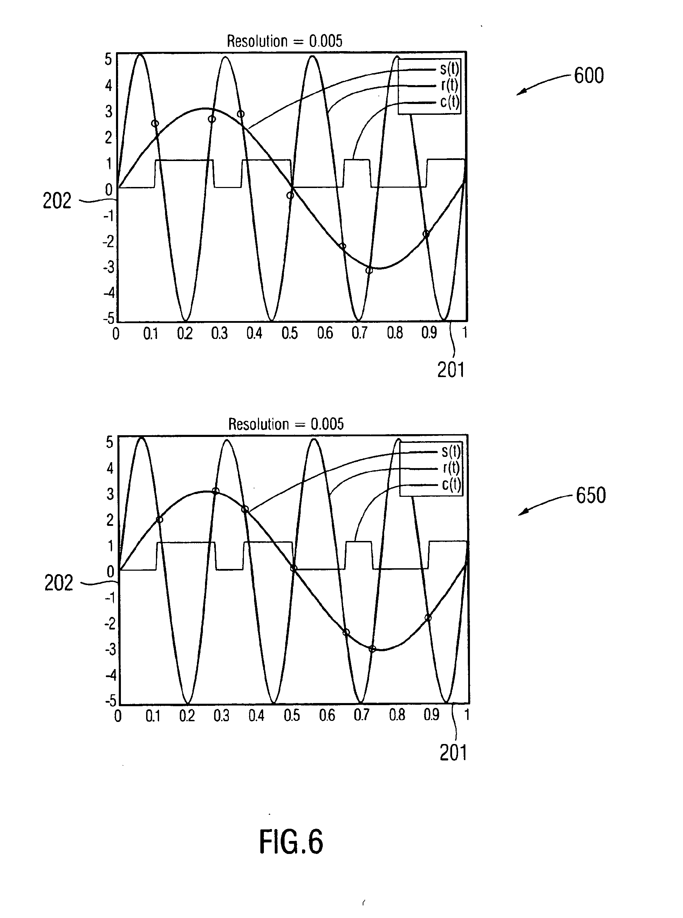

In the following, referring to Fig. 6, analog waveform reconstruction will be explained in more detail.

A first diagram 600 shows the time dependence of the signals s(t), r(t) and c(t) in accordance with Fig. 3 for a first resolution value of 0.005. A second diagram 650 shows the time dependence of these signals s(t), r(t) and c(t) for a second resolution value of 0.0001.

Accurate transition times $T_k$ are determined as described above. Sampled levels are given by known reference waveforms at times $T_k$, $V_k=r(T_k)$, or just known static levels. Samples may be (time, value) pairs $(T_k, V_k)$.

Circles in diagram 600, 650 show the "measured" samples $(T_k, V_k)$ for a resolution of 0.005 (diagram 600) and 0.0001 (diagram 650).

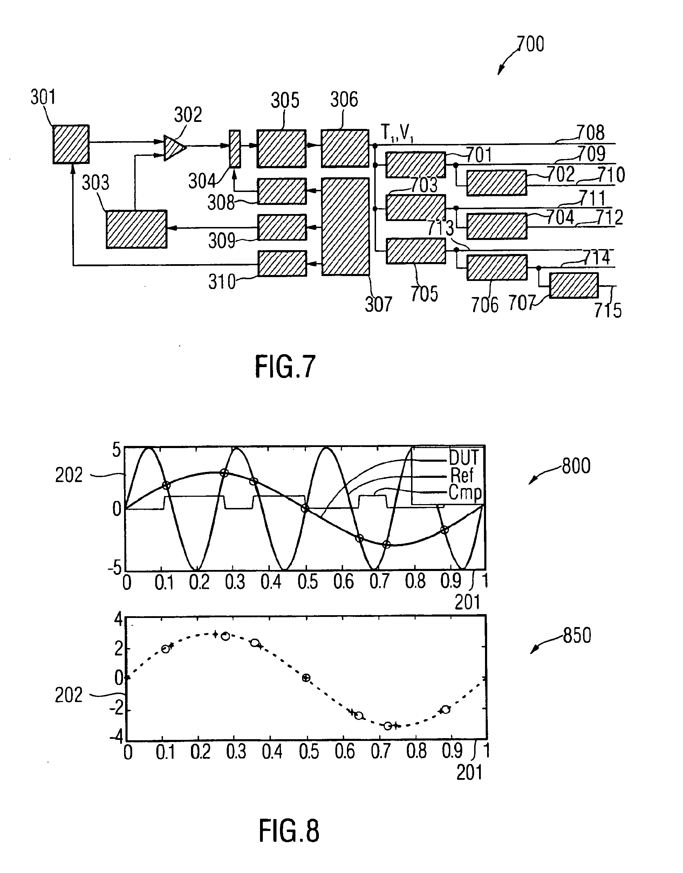

In the following, referring to Fig. 7, a signal processing device 700 according to an exemplary embodiment of the invention will be explained.

The left hand side of Fig. 7 essentially equals to Fig. 3, so that only the additional components will be explained in the following.

The signal processing device 700 comprises a uniform interpolation unit 701, a Fast Fourier Transformation unit 702, a Non-Uniform Fast Fourier Transformation unit 703, an Inverse Fast Fourier Transformation unit 704, a Non-Uniform Discrete Fourier Transformation unit 705, a down conversion unit (frequency shift) 706 and an Inverse Fast Fourier Transformation unit 707.

An output of the transition time algorithm unit 306 is supplied to a first output 708 as a non-uniform time sample signal. Furthermore, the output of the transition time algorithm unit 306 is supplied to an input of the uniform interpolation unit 701. An output of the uniform interpolation unit 701 supplies a uniform time sample signal 709. Furthermore, the output of the uniform interpolation unit 701 is coupled to an input of the FFT unit 702, wherein an output of the FFT unit 702 provides a uniform spectrum signal 710.

Beyond this, the output of the transition time algorithm unit 306 is supplied to an input of the NUFFT unit 703. At an output of the NUFFT unit 703, a uniform spectrum signal 711 is provided. Furthermore, the output of the NUFFT unit 703 is coupled to an input of the Inverse FFT unit 704. At an output of the Inverse FFT unit 704, uniform time samples 712 are provided. Moreover, the output signals of the transition time algorithm unit 306 are supplied to the Non-Uniform DFT unit 705. At an output of the Non-Uniform DFT unit 705, a signal 713 is provided which is indicative of a spectrum at selected user-defined frequencies. Furthermore, the output of the Non-Uniform DFT unit 705 is coupled to an input of the down conversion unit 706. At an output of the down conversion unit 706, a baseband spectrum signal 714 is provided. Furthermore, the output of the down conversion unit 706 is coupled to an input of the Inverse FFT unit 707. At an output of the Inverse FFT unit 707, a uniform baseband sample time signal 715 is provided. In a practical application, usually only a few of the outputs are foreseen, for instance one or two.

The processing according to the embodiment of Fig. 7 allows a transformation of the transition times into usual ADC sample format.

For some applications, non-uniform samples $(T_i, V_i)$ are fine, for instance for eye diagram. However, many applications require data representation with uniformly spaced time samples or spectrum at uniformly spaced frequencies.

In order to achieve this solution, it is possible to use uniform interpolation to transform non-uniformly spaced time samples into samples with uniform time spacing (as common in the art of conventional ADCs). For this purpose, standard FFT can be applied.

It is also possible to use NUFFT (Non-Uniform Fast Fourier Transformation) to calculate a spectrum at uniformly spaced frequencies from non-uniformly spaced time samples. Preferably, NUFFT may be used in combination with FMM (Fast Multipole Method) for fast computation time. Time samples can be calculated using standard inverse FFT.

It is also possible to use Non-Uniform DFT (Non-Uniform Discrete Fourier Transformation, not so "fast") to transform to non-uniformly spaced time samples into a spectrum at selected user-defined frequencies. This may be useful for narrowband (for instance RF) signals.

Fig. 8 shows a first diagram 800 and a second diagram 850 which are similar to the diagrams of Fig. 6.

Fig. 8 illustrates uniform interpolation. It is possible to use reconstruction algorithms to obtain uniformly spaced time data. For this purpose, a Sinc(t) interpolation is possible, a polynomial interpolation (Lagrange interpolation, spline interpolation, linear interpolation) is possible, and/or fractional delay filters may be implemented. The diagram 850 illustrates by the circles non-uniform samples from transition times of a compare signal. The dotted line shows the true DUT waveform. The stars in diagram 850 show the result of a uniform interpolation using spline interpolation, for instance MATLAB interp1(..., 'spline').

In the following, the NUFFT feature will be explained in more detail.

For this purpose, the nomenclature will be defined in the following:

$$x_i \in R, i = 1...N, \text{ time samples}$$

$$f_k = (k-1) \cdot f_0 \in R, k = 1...N, \text{ frequency points}$$

$$X_k = X(f_k) \in C, \text{ spectrum}$$

$$x_i = x(t_i) = \sum_{k=1}^{N} X_k e^{j2\pi(k-1)f_0 t_i}$$

$$W = (w_{ik}) = (e^{j2\pi(k-1)f_0 t_i}), \text{ Non-uniform Fourier matrix}$$

$$w_{ik} = (w_i)^{k-1}, w_i = e^{j2\pi f_0 t_i}$$

$$W = \begin{pmatrix} 1 & w_1 & w_1^2 & \cdots & w_1^{N-1} \\ 1 & w_2 & w_2^2 & \cdots & w_2^{N-1} \\ \vdots & \vdots & \vdots & \ddots & \vdots \\ 1 & w_N & w_N^2 & \cdots & w_N^{N-1} \end{pmatrix} \text{ Vandermonde Matrix}$$

$$\begin{pmatrix} x_1 \\ \vdots \\ x_N \end{pmatrix} = \begin{pmatrix} w_{11} & \cdots & w_{1N} \\ \vdots & \ddots & \vdots \\ w_{N1} & \cdots & w_{NN} \end{pmatrix} \begin{pmatrix} X_1 \\ \vdots \\ X_N \end{pmatrix}$$

$$x = W \cdot X$$

$$X = W^{-1} \cdot x, \text{ Non-uniform FFT}$$

It is possible to use NUFFT to calculate spectrum at uniformly spaced frequencies from non-uniformly spaced time samples. Uniform frequency spacing may make the Fourier matrix a Vandermonde Matrix (which is always invertible for different $x_i$, wherein columns are powers of a column vector) which allows to speed up the transform compared to arbitrary frequencies.

In the following, NUDFT for narrowband signals (RF) will be explained in more detail.

For this purpose, the nomenclature will be defined in the following:

$$x_i \in R, i = 1...N, \text{ time samples}$$

$$f_k \in R, k = 1...P, \text{ frequencies of interest}$$

$$X_k = X(f_k) \in C, \text{ spectrum at frequencies of interest}$$

$$x_i = x(t_i) = \sum_{k=1}^{P} X_k e^{j2\pi f_k t_i}$$

$$W = (w_{ik}) = (e^{j2\pi f_k t_i}), \text{ Non-uniform Fourier matrix}$$

$$\begin{pmatrix} x_1 \\ \vdots \\ x_N \end{pmatrix} = \begin{pmatrix} w_{11} & \cdots & w_{1M} \\ \vdots & \ddots & \vdots \\ w_{N1} & \cdots & w_{NP} \end{pmatrix} \begin{pmatrix} X_1 \\ \vdots \\ X_P \end{pmatrix}$$

$$x = W \cdot X$$

$$X = W^+ \cdot x, \text{ Non-uniform DFT}$$

$$W^+ = (W'W)^{-1}W', \text{ Definition of pseudo inverse}$$

$$W' = (w_{ki}), \text{ Definition of transpose}$$

It is possible to calculate the spectrum only for P frequencies $f_k$ in a (narrow) frequency range of interest $[f_L, f_H]$ to avoid calculation for millions of frequencies from DC to RF.

Optionally, it is possible to include DC (f=0) in NUDFT to tolerate offset errors.

Optionally, it is possible to include known spur frequencies to avoid noise aliasing into the frequencies of interest.

It is also possible to perform down conversion into a base band directly in the frequency domain by a simple frequency shift. No hardware down conversion is needed in this scenario.

When N > B, often N >> P, averaging may improve the estimate ofX. W may become rectangular. Spectrum X may be calculated using Moore-Penrose Pseudo-Inverse $W^+$.

Next, another scenario will be described:

$$x_i \in R, i = 1..N, \text{ time samples}$$

$$f_k = (k_L + k - 1) \cdot f_0 \in R, k = 1..k_H - k_L, \text{ frequencies of interest}$$

$$X_k = X(f_k) \in C, \text{ spectrum at frequencies of interest}$$

$$x_i = x(t_i) = \sum_{k=1}^{k_H - k_L} X_k e^{j2\pi(k_L + k - 1) f_0 t_i}$$

$$W = (w_{ik}) = (e^{j2\pi(k_L + k - 1) f_0 t_i}), \text{ Non-uniform Fourier matrix}$$

$$w_{ik} = (w_i)^{k_L + k - 1}, w_i = e^{j2\pi f_0 t_i}$$

$$W = \begin{pmatrix} w_1^{k_L} & w_1^{k_L+1} & w_1^{k_L+2} & \cdots & w_1^{k_H-1} \\ w_2^{k_L} & w_2^{k_L+1} & w_2^{k_L+2} & \cdots & w_2^{k_H-1} \\ \vdots & \vdots & \vdots & \ddots & \vdots \\ w_N^{k_L} & w_N^{k_L+1} & w_N^{k_L+2} & \cdots & w_N^{k_H-1} \end{pmatrix}$$

$$W = \begin{pmatrix} w_1^{k_L} & \cdots & 0 \\ \vdots & \ddots & \vdots \\ 0 & \cdots & w_N^{k_L} \end{pmatrix} \begin{pmatrix} 1 & w_1 & w_1^2 & \cdots & w_1^{k_H-k_L-1} \\ 1 & w_2 & w_2^2 & \cdots & w_2^{k_H-k_L-1} \\ \vdots & \vdots & \vdots & \ddots & \vdots \\ 1 & w_N & w_N^2 & \cdots & w_N^{k_H-k_L-1} \end{pmatrix}$$

$$\begin{pmatrix} x_1 \\ \vdots \\ x_N \end{pmatrix} = \begin{pmatrix} w_{11} & \cdots & w_{1N} \\ \vdots & \ddots & \vdots \\ w_{N1} & \cdots & w_{NN} \end{pmatrix} \begin{pmatrix} X_1 \\ \vdots \\ X_N \end{pmatrix}$$

$$x = W \cdot X$$

$$X = W^{-1} \cdot x, \text{ Non-uniform FFT}$$

When frequencies are chosen to be equally spaced within a single contiguous frequency range of interest (typical for RF signals), the Fourier matrix is a product of a Vandermonde Matrix and a diagonal matrix which may simplify inversion.

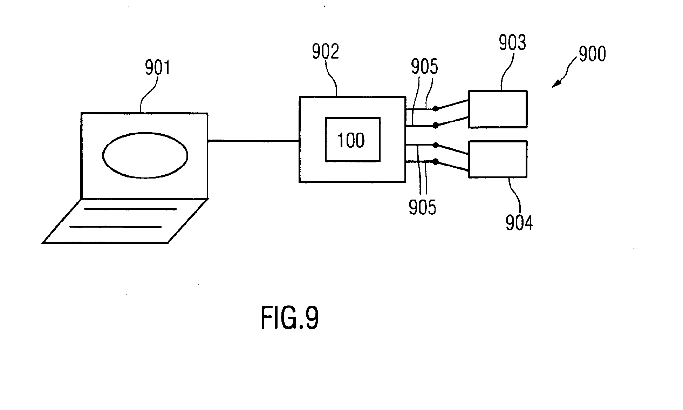

Fig. 9 shows a measurement apparatus 900 according to an exemplary embodiment of the invention.

The measurement apparatus 900 comprises a control computer (like a workstation, a PC or a laptop) 901 which controls the entire test of the measurement apparatus. A test control unit 902 generates and/or receives from DUTs 903, 904 signals, including a repetitive signal 102 related to the measurement carried out by the measurement apparatus 900. Within the test control unit 902 or apart therefrom, a signal processing device 100 having the features as described in Fig. 1 is implemented. The test control unit 902 comprises a plurality of pins 905 which are connected to the devices under test 903, 904 (for instance memories, chips for mobile phones, etc.).

During the test, stimulus signals are supplied to the DUTs 903, 904 so as to perform a specific test pattern, and response signals are evaluated by the test control unit 902 and by the control computer 901.

It should be noted that the term "comprising" does not exclude other elements or features and the "a" or "an" does not exclude a plurality. Also elements described in association with different embodiments may be combined. It should also be noted that reference signs in the claims shall not be construed as limiting the scope of the claims.

**Claims**

1. A signal processing device (100) for processing a repetitive signal (102), the signal processing device (100) comprising:

a determining unit (103) for determining a number of points of time for undersampling the repetitive signal (102),

a comparator unit (105) for comparing the repetitive signal (102) with a reference signal (106), and

a generation unit (130) adapted for generating , at the number of points of time, a digital result signal having a first logical value in case the repetitive signal is larger than the reference signal, and having a second logical value in case the repetitive signal is smaller than the reference signal,

**characterised in that** it further comprises:

an evaluation unit (112) for determining transition times of the digital result signal (110).

2. The signal processing device (100) of claim 1,
adapted for processing a repetitive analog signal (102).

3. The signal processing device (100) of any one of the above claims,
adapted for processing a repetitive modulated radio frequency signal (102).

4. The signal processing device (100) of any one of the above claims,
adapted as an analog-to-digital converter for converting a repetitive analog signal (102) into a digital signal (116).

5. The signal processing device (100) of any one of the above claims,
wherein the determining unit (103) is adapted for determining points of time differing for at least a part of a plurality of repetitions.

6. The signal processing device (100) of any one of the above claims,
wherein the determining unit (103) is adapted for determining points of time differing for at least a part of a plurality of repetitions so as to refine accuracy of signal processing with each additional repetition.

7. The signal processing device (100) of any one of the above claims,
wherein the reference signal (106) is one of the group consisting of a single signal being constant in time, a plurality of signals each being constant in time, a signal varying in time in accordance with a predefined waveform, and a sine signal.

8. The signal processing device (100) of any one of the above claims,
wherein the evaluation unit (112) is adapted for determining the transition times (114) taking into account the signal at points of time related to different ones of a plurality of repetitions.

9. The signal processing device (100) of any one of the above claims,
wherein the number of points of time is larger than a number of repetitions.

10. The signal processing device (100) of any one of the above claims,
comprising a re-sorting unit (111) adapted for re-sorting the digital result signals (110) related to different repetitions in accordance with a chronology of the corresponding points of time within a periodicity of the repetitive signal (102).

11. The signal processing device (100) of claim 1,
wherein the evaluation unit (112) is adapted for determining the transition times (114) based on an analysis of at least one of the group consisting of a last point of time in a sequence in which the digital result signal (110) has the first logical value, and a first point of time in a sequence in which the digital result signal (110) has the second logical value.

12. The signal processing device (100) of claim 1,
wherein the evaluation unit (112) is adapted for determining the transition times (114) based on a statistical analysis of a plurality of points of time forming an interval comprising digital result signals (110) having the first logical value and comprising digital result signals (110) having the second logical value.

13. The signal processing device (100) of claim 1,
wherein the evaluation unit (112) is adapted for determining the transition times (114) based on fitting a mathematical probability function, particularly a cumulative probability density function, to a plurality of points of time forming an interval comprising digital result signals (110) having the first logical value and comprising digital result signals (110) having the second logical value and determining the transition times (114) from a result of the fit.

**14.** The signal processing device (100) of any one of the above claims,
wherein the evaluation unit (112) is adapted to determine the transition times (114) in accordance with a degree of presence of at least one of the group consisting of signal jitter and signal noise.

**15.** The signal processing device (100) of any one of the above claims,
comprising an output signal calculation unit (115) adapted for calculating essentially uniformly spaced output signals (116).

**16.** The signal processing device (100) of claim 15,
wherein the output signal calculation unit (115) is adapted for determining the essentially uniformly spaced output signals (116) by using at least one of the group consisting of a Sinc interpolation, a polynomial interpolation, a Lagrange interpolation, a spline interpolation, a linear interpolation, and a fractional delay filter.

**17.** The signal processing device (100) of claim 15 or 16,
wherein the output signal calculation unit (115) is adapted for calculating the output signals (116) essentially uniformly spaced in time or essentially uniformly spaced in frequency.

**18.** The signal processing device (100) of any one of the claims 15 to 17,
wherein the output signal calculation unit (11S) is adapted for calculating the output signal (116) by performing at least one of the group consisting of a Fast Fourier Transformation, a Non-Uniform Fast Fourier Transformation, a Non-Uniform Fast Fourier Transformation with Fast Multipole Method, and a Non-Uniform Discrete Fourier Transformation.

**19.** The signal processing device (100) of any one of the above claims,
adapted for processing the repetitive signal (102) using coherent sampling.

**20.** The signal processing device (100) of any one of the above claims,
comprising a clock generating unit (108) adapted for generating a common clock signal (109) for a plurality of components (101, 107) of the signal processing device (100).

**21.** The signal processing device (100) of any one of the above claims,
comprising a plurality of clock generating units (108), each adapted for generating an individual clock signal (109a, 109b) for an assigned component (101, 107) of the signal processing device (100), wherein the plurality of clock generating units (108) are frequency-locked to one another.

**22.** The signal processing device (100) of any one of the above claims,
comprising a jitter adding unit adapted to selectively add jitter to the repetitive signal (102).

**23.** The signal processing device (100) of any one of the above claims,
comprising an automatic test equipment unit as a source for providing the repetitive signal (102).

**24.** The signal processing device (100) of any one of the above claims,
adapted as an automatic test equipment for testing a device under test.

**25.** A measurement apparatus (900), comprising
a signal processing device (100) of any one of the above claims for processing a repetitive signal (102) related to a measurement carried out by the measurement apparatus (900).

**26.** The measurement apparatus (900) of claim 25,
adapted to generate, as the repetitive signal (102), a stimulus signal to be applied to a device under test (903, 904) for testing the device under test (903, 904).

**27.** The measurement apparatus (900) of claim 25 or 26,
adapted to receive, as the repetitive signal (102), a response signal from a device under test (903, 904) in response to applying a stimulus signal to the device under test (903, 904) for testing the device under test (903, 904).

**28.** The measurement apparatus (900) of any one of the claims 25 to 27,
comprising at least one of an analog-to-digital converter, a sensor device, a test device for testing a device under test or a substance, a device for chemical, biological and/or pharmaceutical analysis, a fluid separation system adapted for separating compounds of a fluid, a capillary electrophoresis device, a liquid chromatography device, a gas chromatography device, an electronic measurement device, and a mass spectroscopy device.

29. A signal processing method of processing a repetitive signal (102), the method comprising:

determining a number of points of time for undersampling the repetitive signal (102),
comparing the repetitive signal with a reference signal (106), and
generating, at the number of points of time, a digital result signal having a first logical value in case the repetitive signal is larger than the reference signal, and having a second logical value in case the repetitive signal is smaller than the reference signal,
the method being **characterised by** further comprising:
determining transition times (114) of the digital result signal (110).

30. A computer-readable medium, in which a computer program of signal processing is stored, which computer program, when being executed by a processor (100), is adapted to control or carry out the method of claim 29.

31. A program element of signal processing, which program element, when being executed by a processor (100), is adapted to control or carry out the method of claim 29.

**Patentansprüche**

1. Eine Signalverarbeitungsvorrichtung (100) zum Verarbeiten eines sich wiederholenden Signals (102), wobei die Signalverarbeitungsvorrichtung (100) folgende Merkmale aufweist:

eine Bestimmungseinheit (103) zum Bestimmen einer Anzahl von Zeitpunkten für ein Unterabtasten des sich wiederholenden Signals (102),
eine Komparatoreinheit (105) zum Vergleichen des sich wiederholenden Signals (102) mit einem Referenzsignal (106), und
eine Erzeugungseinheit (130), die an der Anzahl von Zeitpunkten zum Erzeugen eines digitalen Ergebnissignals angepasst ist, das einen ersten logischen Wert aufweist, falls das sich wiederholende Signal größer als das Referenzsignal ist, und einen zweiten logischen Wert aufweist, falls das sich wiederholende Signal kleiner als das Referenzsignal ist,
**dadurch gekennzeichnet, dass** dieselbe ferner folgendes Merkmal aufweist:
eine Auswertungseinheit (112) zum Bestimmen von Übergangszeiten des digitalen Ergebnissignals (110).

2. Die Signalverarbeitungsvorrichtung (100) gemäß Anspruch 1,
die zum Verarbeiten eines sich wiederholenden analogen Signals (102) angepasst ist.

3. Die Signalverarbeitungsvorrichtung (100) gemäß einem der obigen Ansprüche,
die zum Verarbeiten eines sich wiederholenden modulierten Hochfrequenzsignals (102) angepasst ist.

4. Die Signalverarbeitungsvorrichtung (100) gemäß einem der obigen Ansprüche,
die als ein Analog-zu-Digital-Wandler zum Umwandeln eines sich wiederholenden analogen Signals (102) in ein digitales Signal (116) angepasst ist.

5. Die Signalverarbeitungsvorrichtung (100) gemäß einem der obigen Ansprüche,
bei der die Bestimmungseinheit (103) zum Bestimmen von Zeitpunkten angepasst ist, die für zumindest einen Teil einer Mehrzahl von Wiederholungen unterschiedlich sind.

6. Die Signalverarbeitungsvorrichtung (100) gemäß einem der obigen Ansprüche,
bei der die Bestimmungseinheit (103) zum Bestimmen von Zeitpunkten angepasst ist, die für zumindest einen Teil einer Mehrzahl von Wiederholungen unterschiedlich sind, um eine Genauigkeit einer Signalverarbeitung mit jeder zusätzlichen Wiederholung zu verfeinern.

7. Die Signalverarbeitungsvorrichtung (100) gemäß einem der obigen Ansprüche,
bei der das Referenzsignal (106) eines aus der Gruppe ist, die ein einziges Signal, das zeitlich konstant ist, eine Mehrzahl von Signalen, die jeweils zeitlich konstant sind, ein Signal, das gemäß einem vorbestimmten Signalverlauf zeitlich variiert, und ein Sinussignal umfasst.

8. Die Signalverarbeitungsvorrichtung (100) gemäß einem der obigen Ansprüche, bei der die Auswertungseinheit (112) zum Bestimmen der Übergangszeiten (114) unter Berücksichtigung des Signals zu Zeitpunkten angepasst ist, die auf unterschiedliche von einer Mehrzahl von Wiederholungen bezogen sind.

9. Die Signalverarbeitungsvorrichtung (100) gemäß einem der obigen Ansprüche, bei der die Anzahl von Zeitpunkten größer als eine Anzahl von Wiederholungen ist.

10. Die Signalverarbeitungsvorrichtung (100) gemäß einem der obigen Ansprüche, die eine Neusortiereinheit (111) aufweist, die zum Neusortieren der digitalen Ergebnissignale (110), die auf unterschiedliche Wiederholungen bezogen sind, gemäß einer Chronologie der entsprechenden Zeitpunkte innerhalb einer Periodizität des sich wiederholenden Signals (102) angepasst ist.

11. Die Signalverarbeitungsvorrichtung (100) gemäß Anspruch 1, bei der die Auswertungseinheit (112) zum Bestimmen der Übergangszeiten (114) basierend auf einer Analyse von zumindest einem aus der Gruppe angepasst ist, die einen letzten Zeitpunkt in einer Sequenz, in der das digitale Ergebnissignal (110) den ersten logischen Wert aufweist, und einen ersten Zeitpunkt in einer Sequenz, in der das digitale Ergebnissignal (110) den zweiten logischen Wert aufweist, umfasst.

12. Die Signalverarbeitungsvorrichtung (100) gemäß Anspruch 1, bei der die Auswertungseinheit (112) zum Bestimmen der Übergangszeiten (114) basierend auf einer statistischen Analyse einer Mehrzahl von Zeitpunkten angepasst ist, die ein Intervall bilden, das digitale Ergebnissignale (110) mit dem ersten logischen Wert aufweist und digitale Ergebnissignale (110) mit dem zweiten logischen Wert aufweist.

13. Die Signalverarbeitungsvorrichtung (100) gemäß Anspruch 1, bei der die Auswertungseinheit (112) zum Bestimmen der Übergangszeiten (114) basierend auf einer Anpassung einer mathematischen Wahrscheinlichkeitsfunktion, insbesondere einer kumulativen Wahrscheinlichkeitsdichtefunktion, an eine Mehrzahl von Zeitpunkten, die ein Intervall bilden, das digitale Ergebnissignale (110) mit dem ersten logischen Wert aufweist und digitale Ergebnissignale (110) mit dem zweiten logischen Wert aufweist, und zum Bestimmen der Übergangszeiten (114) aus einem Ergebnis der Anpassung angepasst ist.

14. Die Signalverarbeitungsvorrichtung (100) gemäß einem der obigen Ansprüche, bei der die Auswertungseinheit (112) angepasst ist, um die Übergangszeiten (114) gemäß einem Grad eines Vorhandenseins von zumindest einem aus der Gruppe, die Signalzittern und Signalrauschen umfasst, zu bestimmen.

15. Die Signalverarbeitungsvorrichtung (100) gemäß einem der obigen Ansprüche, die eine Ausgangssignalberechnungseinheit (115) aufweist, die zum Berechnen von im Wesentlichen einheitlich beabstandeten Ausgangssignalen (116) angepasst ist.

16. Die Signalverarbeitungsvorrichtung (100) gemäß Anspruch 15, bei der die Ausgangssignalberechnungseinheit (115) zum Bestimmen der im Wesentlichen einheitlich beabstandeten Ausgangssignale (116) durch ein Verwenden zumindest einer aus der Gruppe angepasst ist, die eine Sinc-Interpolation, eine polynomische Interpolation, eine Lagrange-Interpolation, eine Spline-Interpolation, eine lineare Interpolation und ein Teilverzögerungsfilter umfasst.

17. Die Signalverarbeitungsvorrichtung (100) gemäß Anspruch 15 oder 16, bei der die Ausgangssignalberechnungseinheit (115) zum Berechnen der Ausgangssignale (116) angepasst ist, die im Wesentlichen zeitlich einheitlich beabstandet sind oder frequenzmäßig im Wesentlichen einheitlich beabstandet sind.

18. Die Signalverarbeitungsvorrichtung (100) gemäß einem der Ansprüche 15 bis 17, bei der die Ausgangssignalberechnungseinheit (115) zum Berechnen des Ausgangssignals (116) durch ein Durchführen von zumindest einem aus der Gruppe angepasst ist, die eine schnelle Fourier-Transformation, eine nichteinheitliche schnelle Fourier-Transformation, eine nicht-einheitliche schnelle Fourier-Transformation mit schnellem Multipol-Verfahren und eine nicht-einheitliche diskrete Fourier-Transformation umfasst.

**19.** Die Signalverarbeitungsvorrichtung (100) gemäß einem der obigen Ansprüche,
die zum Verarbeiten des sich wiederholenden Signals (102) unter Verwendung von kohärentem Abtasten angepasst ist.

**20.** Die Signalverarbeitungsvorrichtung (100) gemäß einem der obigen Ansprüche,
die eine Takterzeugungseinheit (108) aufweist, die zum Erzeugen eines gemeinsamen Taktsignals (109) für eine Mehrzahl von Komponenten (101, 107) der Signalverarbeitungsvorrichtung (100) angepasst ist.

**21.** Die Signalverarbeitungsvorrichtung (100) gemäß einem der obigen Ansprüche,
die eine Mehrzahl von Takterzeugungseinheiten (108) aufweist, die jeweils zum Erzeugen eines einzelnen Taktsignals (109a, 109b) für eine zugewiesene Komponente (101, 107) der Signalverarbeitungsvorrichtung (100) angepasst ist, wobei die Mehrzahl von Takterzeugungseinheiten (108) frequenzmäßig aufeinander verriegelt sind.

**22.** Die Signalverarbeitungsvorrichtung (100) gemäß einem der obigen Ansprüche,
die eine Zitterhinzufügungseinheit aufweist, die angepasst ist, um selektiv Zittern zu dem sich wiederholenden Signal (102) hinzuzufügen.

**23.** Die Signalverarbeitungsvorrichtung (100) gemäß einem der obigen Ansprüche,
die eine automatische Testausrüstungseinheit als eine Quelle zum Liefern des sich wiederholenden Signals (102) aufweist.

**24.** Die Signalverarbeitungsvorrichtung (100) gemäß einem der obigen Ansprüche,
die als eine automatische Testausrüstung zum Testen eines Testobjekts angepasst ist.

**25.** Eine Messvorrichtung (900), die folgendes Merkmal aufweist:

eine Signalverarbeitungsvorrichtung (100) gemäß einem der obigen Ansprüche zum Verarbeiten eines sich wiederholenden Signals (102), das auf eine Messung bezogen ist, die durch die Messvorrichtung (900) ausgeführt wird.

**26.** Die Messvorrichtung (900) gemäß Anspruch 25,
die angepasst ist, um als das sich wiederholende Signal (102) ein Stimulussignal zu erzeugen, das an ein Testobjekt (903, 904) zum Testen des Testobjekts (903, 904) angelegt werden soll.

**27.** Die Messvorrichtung (900) gemäß Anspruch 25 oder 26,
die angepasst ist, um ein Antwortsignal von einem Testobjekt (903, 904) ansprechend auf das Anlegen eines Stimulussignals an das Testobjekt (903, 904) zum Testen des Testobjekts (903, 904) als das sich wiederholende Signal (102) zu empfangen.

**28.** Die Messvorrichtung (900) gemäß einem der Ansprüche 25 bis 27,
die zumindest einen Analog-zu-Digital-Wandler, eine Sensorvorrichtung, eine Testvorrichtung zum Testen eines Testobjekts oder einer Substanz, eine Vorrichtung für chemische, biologische und/oder pharmazeutische Analyse, ein Fluidtrennungssystem, das zum Trennen von Verbindungen eines Fluids angepasst ist, eine Kapillarelektrophoresevorrichtung, eine Flüssigkeitschromatographievorrichtung, eine Gaschromatographievorrichtung, eine elektronische Messvorrichtung und eine Massenspektroskopievorrichtung aufweist.

**29.** Ein Signalverarbeitungsverfahren zum Verarbeiten eines sich wiederholenden Signals (102), wobei das Verfahren folgende Schritte aufweist:

Bestimmen einer Anzahl von Zeitpunkten für ein Unterabtasten des sich wiederholenden Signals (102),
Vergleichen des sich wiederholenden Signals (102) mit einem Referenzsignal (106), und
Erzeugen eines digitalen Ergebnissignals an der Anzahl von Zeitpunkten, das einen ersten logischen Wert aufweist, falls das sich wiederholende Signal größer als das Referenzsignal ist, und einen zweiten logischen Wert aufweist, falls das sich wiederholende Signal kleiner als das Referenzsignal ist,
wobei das Verfahren **dadurch gekennzeichnet ist, dass** dasselbe ferner folgenden Schritt aufweist:
Bestimmen von Übergangszeiten des digitalen Ergebnissignals (110).

**30.** Ein computerlesbares Medium, in dem ein Computerprogramm einer Signalverarbeitung gespeichert ist, wobei das Computerprogramm, wenn dasselbe durch einen Prozessor (100) ausgeführt wird, angepasst ist, um das Verfahren gemäß Anspruch 29 zu steuern oder auszuführen.

31. Ein Programmelement einer Signalverarbeitung, wobei das Programmelement, wenn dasselbe durch einen Prozessor (100) ausgeführt wird, angepasst ist, um das Verfahren gemäß Anspruch 29 zu steuern oder auszuführen.

**Revendications**

1. Dispositif de traitement de signal (100) pour traiter un signal répétitif (102), le dispositif de traitement de signal (100) comprenant:

   une unité de détermination (103) destinée à déterminer un nombre de points dans le temps pour le sous-échantillonnage du signal répétitif (102),
   une unité de comparaison (105) destinée à comparer le signal répétitif (102) à un signal de référence (106), et
   une unité de génération (130) adaptée pour générer, au nombre de points dans le temps, un signal de résultat numérique ayant une première valeur logique au cas où le signal répétitif est supérieur au signal de référence, et ayant une deuxième valeur logique au cas où le signal répétitif est inférieur au signal de référence,
   **caractérisé par le fait qu'**il comprend par ailleurs:
   une unité d'évaluation (112) destinée à déterminer les temps de transition du signal de résultat numérique (110).

2. Dispositif de traitement de signal (100) selon la revendication 1,
   adapté pour traiter un signal analogique répétitif (102).

3. Dispositif de traitement de signal (100) selon l'une quelconque des revendications ci-dessus,
   adapté pour traiter un signal de radiofréquence répétitif modulé (102).

4. Dispositif de traitement de signal (100) selon l'une quelconque des revendications ci-dessus,
   adapté comme convertisseur analogique-numérique destiné à convertir un signal analogique répétitif (102) en un signal numérique (116).

5. Dispositif de traitement de signal (100) selon l'une quelconque des revendications ci-dessus,
   dans lequel l'unité de détermination (103) est adaptée pour déterminer des points dans le temps différents pour au moins une partie d'une pluralité de répétitions.

6. Dispositif de traitement de signal (100) selon l'une quelconque des revendications ci-dessus,
   dans lequel l'unité de détermination (103) est adaptée pour déterminer des points dans le temps différents pour au moins une partie d'une pluralité de répétitions, de manière à raffiner la précision du traitement de signal à chaque répétition additionnelle.

7. Dispositif de traitement de signal (100) selon l'une quelconque des revendications ci-dessus,
   dans lequel le signal de référence (106) est l'un parmi le groupe composé d'un seul signal constant dans le temps, chacun d'une pluralité de signaux étant constant dans le temps, un signal variant dans le temps selon une forme d'onde prédéfinie, et un signal sinusoïdal.

8. Dispositif de traitement de signal (100) selon l'une quelconque des revendications ci-dessus,
   dans lequel l'unité d'évaluation (112) est adaptée pour déterminer les temps de transition (114) en tenant compte du signal aux points dans le temps relatifs à différentes parmi une pluralité de répétitions.

9. Dispositif de traitement de signal (100) selon l'une quelconque des revendications ci-dessus,
   dans lequel le nombre de points dans le temps est supérieur au nombre de répétitions.

10. Dispositif de traitement de signal (100) selon l'une quelconque des revendications ci-dessus,
    comprenant une unité de retriage (111) adaptée pour retrier les signaux de résultat numériques (110) relatifs à différentes répétitions selon une chronologie des points dans le temps correspondants dans une périodicité du signal répétitif (102).

11. Dispositif de traitement de signal (100) selon la revendication 1,

dans lequel l'unité d'évaluation (112) est adaptée pour déterminer les temps de transition (114) sur base d'une analyse d'au moins l'un parmi le groupe composé d'un dernier point dans le temps dans une séquence dans laquelle le signal de résultat numérique (110) a la première valeur logique, et un premier point dans le temps dans une séquence dans laquelle le signal de résultat numérique (110) a la deuxième valeur logique.

12. Dispositif de traitement de signal (100) selon la revendication 1,
dans lequel l'unité d'évaluation (112) est adaptée pour déterminer les temps de transition (114) sur base d'une analyse statistique d'une pluralité de points dans le temps formant un intervalle comprenant des signaux de résultat numériques (110) ayant la première valeur logique et comprenant des signaux de résultat numériques (110) ayant la deuxième valeur logique.

13. Dispositif de traitement de signal (100) selon la revendication 1,
dans lequel l'unité d'évaluation (112) est adaptée pour déterminer les temps de transition (114) sur base de l'ajustage d'une fonction de probabilité mathématique, en particulier une fonction de densité de probabilité cumulative, à une pluralité de points dans le temps formant un intervalle comprenant des signaux de résultat numériques (110) ayant la première valeur logique et comprenant des signaux de résultat numériques (110) ayant la deuxième valeur logique et déterminer les temps de transition (114) à partir d'un résultat de l'ajustage.

14. Dispositif de traitement de signal (100) selon l'une quelconque des revendications ci-dessus,
dans lequel l'unité d'évaluation (112) est adaptée pour déterminer les temps de transition (114) selon un degré de présence d'au moins l'un parmi le groupe composé de gigue de signal et de bruit de signal.

15. Dispositif de traitement de signal (100) selon l'une quelconque des revendications ci-dessus,
comprenant une unité de calcul de signal de sortie (115) adaptée pour calculer les signaux de sortie essentiellement espacés uniformément (116).

16. Dispositif de traitement de signal (100) selon la revendication 15,
dans lequel l'unité de calcul de signal de sortie (115) est adaptée pour déterminer les signaux de sortie essentiellement espacés uniformément (116) en utilisant au moins l'un parmi le groupe composé d'une interpolation Sync, d'une interpolation polynôme, d'une interpolation de Lagrange, d'une interpolation à spline, d'une interpolation linéaire, et d'un filtre de temporisation fractionnelle.

17. Dispositif de traitement de signal (100) selon la revendication 15 ou 16,
dans lequel l'unité de calcul de signal de sortie (115) est adapté pour calculer les signaux de sortie (116) essentiellement espacés uniformément dans le temps ou essentiellement espacés uniformément en fréquence.

18. Dispositif de traitement de signal (100) selon l'une quelconque des revendications 15 à 17,
dans lequel l'unité de calcul de signal de sortie (115) est adaptée pour calculer le signal de sortie (116) en effectuant au moins l'une parmi le groupe composé d'une Transformation de Fourier Rapide, d'une Transformation de Fourier Rapide Non Uniforme, d'une Transformation de Fourier Rapide Non Uniforme avec la Méthode Multipôle Rapide, et une Transformation de Fourier Discrète Non Uniforme.

19. Dispositif de traitement de signal (100) selon l'une quelconque des revendications ci-dessus,
adapté pour traiter le signal répétitif (102) à l'aide d'un échantillonnage cohérent.

20. Dispositif de traitement de signal (100) selon l'une quelconque des revendications ci-dessus,
comprenant une unité de génération de signal d'horloge (108) adaptée pour générer un signal d'horloge commun (109) pour une pluralité de composants (101, 107) du dispositif de traitement de signal (100).

21. Dispositif de traitement de signal (100) selon l'une quelconque des revendications ci-dessus,
comprenant une pluralité d'unités de génération de signal d'horloge (108) adaptées, chacune, pour générer un signal d'horloge individuel (109a, 109b) pour un composant attribué (101, 107) du dispositif de traitement de signal (100), dans lequel la pluralité d'unités de génération de signal d'horloge (108) sont verrouillées en fréquence l'une par rapport à l'autre.

22. Dispositif de traitement de signal (100) selon l'une quelconque des revendications ci-dessus,
comprenant une unité d'addition de gigue adaptée pour ajouter sélectivement de la gigue au signal répétitif (102).

**23.** Dispositif de traitement de signal (100) selon l'une quelconque des revendications ci-dessus,
comprenant une unité de matériel de test automatique comme source pour fournir le signal répétitif (102).

**24.** Dispositif de traitement de signal (100) selon l'une quelconque des revendications ci-dessus,
adapté comme matériel de test automatique pour tester un dispositif à tester.

**25.** Appareil de mesure (900), comprenant:

un dispositif de traitement de signal (100) selon l'une quelconque des revendications ci-dessus destiné à traiter un signal répétitif (102) relatif à une mesure effectuée par l'appareil de mesure (900).

**26.** Appareil de mesure (900) selon la revendication 25,
adapté pour générer, comme signal répétitif (102), un signal de stimulus à appliquer à un dispositif à tester (903, 904) pour tester le dispositif à tester (903, 904).

**27.** Appareil de mesure (900) selon la revendication 25 ou 26,
adapté pour recevoir, comme signal répétitif (102), un signal de réponse d'un dispositif à tester (903, 904) en réponse à l'application d'un signal de stimulus au dispositif à tester (903, 904) pour tester le dispositif à tester (903, 904).

**28.** Appareil de mesure (900) selon l'une quelconque des revendications 25 à 27,
comprenant au moins l'un parmi un convertisseur analogique-numérique, un dispositif capteur, un dispositif de test pour tester un dispositif à tester ou une substance, un dispositif d'analyse chimique, biologique et/ou pharmaceutique, un système de séparation de fluides adapté pour séparer des composés d'un fluide, un dispositif d'électrophorèse capillaire, un dispositif de chromatographie des liquides, un dispositif de chromatographie des gaz, un dispositif de mesure électronique, et un dispositif de spectroscopie dans la masse.

**29.** Procédé de traitement de signal pour le traitement d'un signal répétitif (102), le procédé comprenant:

déterminer un nombre de points dans le temps pour sous-échantillonner le signal répétitif (102),
comparer le signal répétitif avec un signal de référence (106), et
générer, au nombre de points dans le temps, un signal de résultat numérique ayant une première valeur logique au cas où le signal répétitif est supérieur au signal de référence, et ayant une deuxième valeur logique au cas où le signal répétitif est inférieur au signal de référence,
procédé **caractérisé par le fait qu'**il comprend par ailleurs:
déterminer les temps de transition (114) du signal de résultat numérique (110).

**30.** Support lisible en ordinateur, dans lequel est mémorisé un programme d'ordinateur de traitement de signal, programme d'ordinateur qui est adapté, lorsqu'il est exécuté par un processeur (100), pour commander la réalisation du procédé selon la revendication 29.

**31.** Elément de programme de traitement de signal, élément de programme qui est adapté, lorsqu'il est exécuté par un processeur (100), pour commander la réalisation du procédé selon la revendication 29.

FIG.1

R=0.7, N=32, M=3, K=1

time

Signal repetitions overlaid

time modulo 1/M=1/3

FIG.2

FIG.3

FIG.4

FIG.5

FIG.6

EP 2 044 692 B1

FIG.7

FIG.8

25

FIG.9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6462693 B1
- US 6429799 B1
- US 20040070529 A1
- US 2005219107 A1
- US 6661836 B1

**Non-patent literature cited in the description**

- **S. Sunter.** An Automated, Complete, Structural Test Solution for SERDES. *IEEE International Test Conference,* 2004, 95-104